# EUROPEAN PATENT APPLICATION

(11) **EP 1 811 588 A2**
(43) Date of publication of application: **25.07.2007**
(21) Application number: 07250261.0
(22) Date of filing: 23.01.2007
(51) Int. Cl.: H01L 51/52

(54) **Organic light emitting display and method of fabricating the same**

(30) Priority: 23.01.2006 KR 20060007026; 21.02.2006 KR 20060016854; 21.02.2006 KR 20060016855
(71) Applicant: Samsung SDI Co., Ltd., Suwon-Si, Kyungki-do (KR)
(72) Inventor: Choi, Dong-Soo, Samsung SDI Co., Ltd., Suwon-si Gyeonggi-do (KR); Park, Jin-Woo, Samsung SDI Co., Ltd., Suwon-si Gyeonggi-do (KR); Kwak, Won-Kyu, Samsung SDI Co., Ltd., Suwon-si Gyeonggi-do (KR); Kim, Deuk Jong, Samsung SDI Co., Ltd., Suwon-si Gyeonggi-do (KR); Song, Seung Yong, Samsung SDI Co., Ltd., Suwon-si Gyeonggi-do (KR)
(74) Representative: Mounteney, Simon James

(57) **Abstract**

An OLED having an improved adhesion characteristic and a method of fabricating the same are provided. The OLED includes: a substrate having a pixel region and a non-pixel region except the pixel region; and an encapsulation substrate for encapsulating the substrate. The pixel region includes: a thin film transistor including a semiconductor layer, a gate electrode, and source and drain electrodes; a first electrode electrically connected with the thin film transistor; a pixel defining layer disposed on the first electrode; an organic layer having at least an emissive layer formed on the first electrode and the pixel defining layer; a second electrode disposed on the organic layer; and at least one inorganic layer. The non-pixel region includes at least one inorganic layer, and a frit disposed on the inorganic layer to encapsulate the substrate and the encapsulation substrate.

## Description

### BACKGROUND OF THE INVENTION

### Field of the Invention

The present invention relates to an organic light emitting display device (OLED) and a method of fabricating the same, and more particularly, to an OLED having an improved adhesion characteristic and a method of fabricating the same.

### Description of the Related Art

Recently, flat panel displays, for example, liquid crystal display devices, organic light emitting display devices and plasma display panels (PDPs), which are free of the disadvantages of some display devices such as cathode ray tubes (CRTs), have been receiving a lot of attention.

Since liquid crystal display devices are not self-emissive devices but passive devices, they have limits in brightness, contrast, viewing angle, size and so on. While PDPs are self-emissive devices, they are heavy, have high power consumption, and are complicated to fabricate compared to other flat panel display devices.

On the other hand, since organic light emitting devices are self-emissive devices, they have excellent viewing angle and contrast. Also, since they do not need a backlight, they can be made thin and lightweight and have lower power consumption. Moreover, they have advantages such as a fast response speed and being driven by direct current at a low voltage, durable in withstanding external impact because they are formed of solids, operable over a wide range of temperatures, and relatively simple to manufacture.

### SUMMARY

According to a first aspect of the invention, there is provided an organic light emitting display device as set out in claim 1. Preferred features of this aspect are set out in Claims 2 to 17.

According to a second aspect of the invention, there is provided a method of fabricating an organic light emitting display as set out in Claim 18. Preferred features of this aspect are set out in Claims 19 to 21.

According to a third aspect of the invention, there is provided an organic light emitting display as set out in Claim 22. Preferred features of this aspect are set out in Claims 23 to 27.

Embodiment of the invention provide an organic light emitting display device (OLED) having an improved adhesion characteristic and a method of fabricating the same.

In some embodiments of the invention, an OLED comprises: a substrate having a pixel region and a non-pixel region except the pixel region; and an encapsulation substrate for encapsulating the substrate. The pixel region comprises: a thin film transistor including a semiconductor layer, a gate electrode, and source and drain electrodes; a first electrode electrically connected with the thin film transistor; a pixel defining layer disposed on the first electrode; an organic layer having at least an emissive layer formed on the first electrode and the pixel defining layer; a second electrode disposed on the organic layer; and at least one inorganic layer. The non-pixel region comprises at least one inorganic layer, and a frit disposed on the inorganic layer to encapsulate the substrate and the encapsulation substrate.

In other embodiments of the invention, a method of fabricating an OLED comprises: preparing a substrate comprising a pixel region and a non-pixel region; forming a thin film transistor including a semiconductor layer, a gate electrode, and source and drain electrodes on the substrate in the pixel region; forming at least one inorganic layer on the entire surface of the substrate; forming a first electrode to be connected with the thin film transistor in the pixel region; forming a pixel defining layer on the first electrode; etching and removing the pixel defining layer on the inorganic layer of the non-pixel region; forming an organic layer including at least an emissive layer on the first electrode and the pixel defining layer in the pixel region; forming a second electrode on the entire surface of the substrate; etching and removing the second electrode in the non-pixel region; and applying a frit along edges of the substrate or an encapsulation substrate and encapsulating the substrate.

In still other embodiments of the invention, an OLED comprises: a substrate including at least a thin film transistor, an inorganic layer formed on the thin film transistor, an organic planarization layer formed on the inorganic layer, and an organic light emitting diode formed on the organic planarization layer; an encapsulation substrate adhered to the substrate; and a frit interposed between the substrate and the encapsulation substrate and contacting the inorganic layer.

In yet other embodiments of the invention, a method of fabricating an OLED, comprises: disposing a substrate including a thin film transistor, an inorganic layer formed on the thin film transistor, an organic planarization layer formed on the inorganic layer, and an organic light emitting diode formed on the organic planarization layer; etching a region of the organic planarization layer to expose one region of the inorganic layer; disposing an encapsulation substrate on which a frit is applied along edges; adhering the encapsulation substrate to the substrate so that the frit directly contacts the exposed region of the inorganic layer; and melting the frit and sealing the substrate with the encapsulation substrate.

In yet other embodiments of the invention, an OLED comprises: a substrate including at least a thin film transistor, an organic planarization layer formed on the thin film transistor, and an inorganic layer and an organic layer which are sequentially stacked on one region of the organic planarization layer; an encapsulation substrate adhered to the substrate to seal at least the organic layer; and a frit interposed between the substrate and the encapsulation substrate and contacting the inorganic layer.

In yet other embodiments of the invention, a method of fabricating an OLED comprises: disposing a substrate including at least a thin film transistor, an organic planarization layer formed on the thin film transistor, and inorganic and organic layers sequentially stacked on one region of the organic planarization layer; disposing an encapsulation substrate on which a frit is applied along edges; adhering the encapsulation substrate to the substrate so that the frit directly contacts the inorganic layer; and melting the frit and sealing the substrate with the encapsulated layer.

### BRIEF DESCRIPTION OF THE DRAWINGS

The above and other features of the invention will be described in reference to certain embodiments thereof with reference to the attached drawings in which:

FIG. 1 is a cross-sectional view of an OLED;

FIGS. 2A to 2D are cross-sectional views of an OLED according to a first embodiment of the invention;

FIGS. 3A to 3G are cross-sectional views of an OLED according to a second embodiment of the invention;

FIGS. 4A to 4F are cross-sectional views of an OLED according to a third embodiment of the invention;

FIG. 5 is a schematic exploded view of a passive matrix type organic light emitting display device in accordance with one embodiment;

FIG 6 is a schematic exploded view of an active matrix type organic light emitting display device in accordance with one embodiment;

FIG. 7 is a schematic top plan view of an organic light emitting display in accordance with one embodiment;

FIG. 8 is a cross-sectional view of the organic light emitting display of FIG. 7, taken along the line d-d; and

FIG. 9 is a schematic perspective view illustrating mass production of organic light emitting devices in accordance with one embodiment.

### DETAILED DESCRIPTION OF CERTAIN INVENTIVE EMBODIMENTS

The invention will now be described more fully hereinafter with reference to the accompanying drawings, in which exemplary embodiments of the invention are shown. In the drawings, the thicknesses of layers and regions are exaggerated for clarity. The same reference numerals are used to denote the same elements throughout the specification.

An organic light emitting display (OLED) is a display device comprising an array of organic light emitting diodes. Organic light emitting diodes are solid state devices which include an organic material and are adapted to generate and emit light when appropriate electrical potentials are applied.

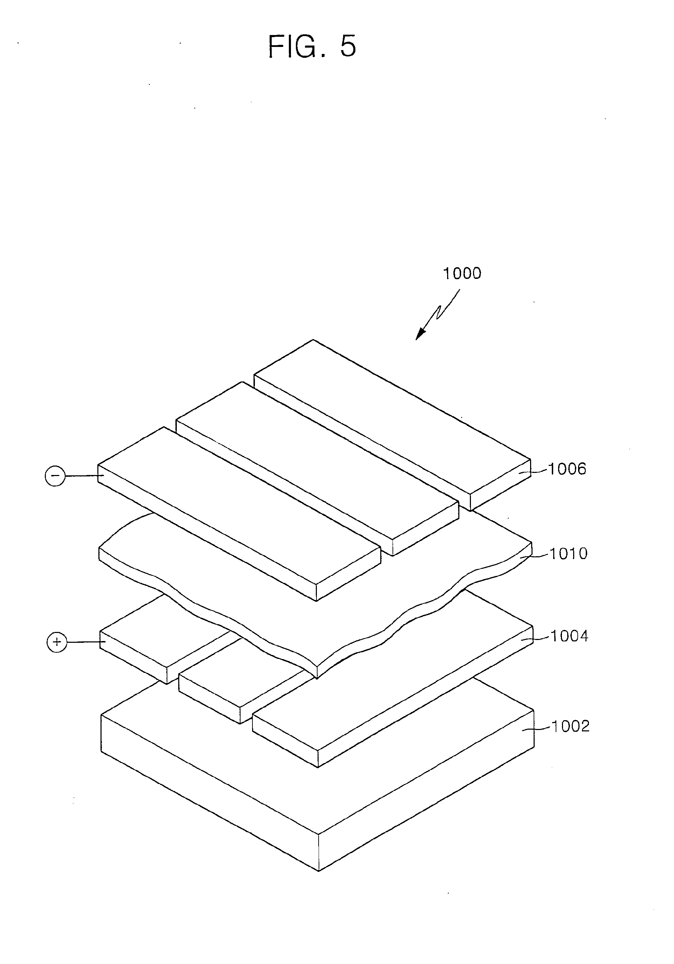

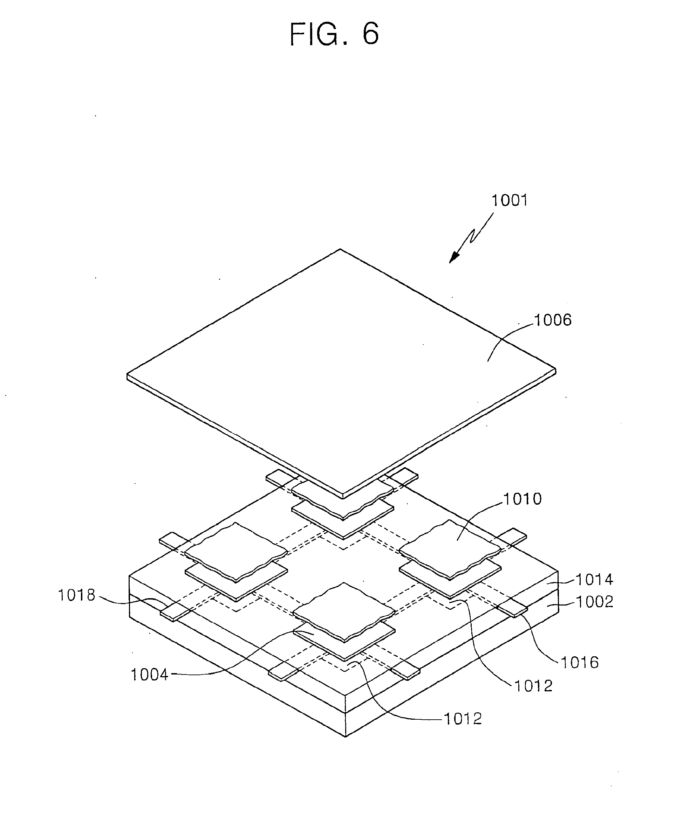

OLEDs can be generally grouped into two basic types dependent on the arrangement with which the stimulating electrical current is provided. Fig. 5 schematically illustrates an exploded view of a simplified structure of a passive matrix type OLED 1000. Fig. 6 schematically illustrates a simplified structure of an active matrix type OLED 1001. In both configurations, the OLED 1000, 1001 includes OLED pixels built over a substrate 1002, and the OLED pixels include an anode 1004, a cathode 1006 and an organic layer 1010. When an appropriate electrical current is applied to the anode 1004, electric current flows through the pixels and visible light is emitted from the organic layer.

Referring to Fig. 5, the passive matrix OLED (PMOLED) design includes elongate strips of anode 1004 arranged generally perpendicular to elongate strips of cathode 1006 with organic layers interposed therebetween. The intersections of the strips of cathode 1006 and anode 1004 define individual OLED pixels where light is generated and emitted upon appropriate excitation of the corresponding strips of anode 1004 and cathode 1006. PMOLEDs provide the advantage of relatively simple fabrication.

Referring to Fig. 6, the active matrix OLED (AMOLED) includes driving circuits 1012 arranged between the substrate 1002 and an array of OLED pixels. An individual pixel of AMOLEDs is defined between the common cathode 1006 and an anode 1004, which is electrically isolated from other anodes. Each driving circuit 1012 is coupled with an anode 1004 of the OLED pixels and further coupled with a data line 1016 and a scan line 1018. The scan lines 1018 supply scan signals that select rows of the driving circuits, and the data lines 1016 supply data signals for particular driving circuits. The data signals and scan signals stimulate the local driving circuits 1012, which excite the anodes 1004 so as to emit light from their corresponding pixels.

In the illustrated AMOLED, the local driving circuits 1012, the data lines 1016 and scan lines 1018 are buried in a planarization layer 1014, which is interposed between the pixel array and the substrate 1002. The planarization layer 1014 provides a planar top surface on which the organic light emitting pixel array is formed. The planarization layer 1014 may be formed of organic or inorganic materials, and formed of two or more layers although shown as a single layer. The local driving circuits 1012 are typically formed with thin film transistors (TFT) and arranged in a grid or array under the OLED pixel array. The local driving circuits 1012 may be at least partly made of organic materials, including organic TFT. AMOLEDs have the advantage of fast response time improving their desirability for use in displaying data signals. Also, AMOLEDs have the advantages of consuming less power than passive matrix OLEDs.

Referring to common features of the PMOLED and AMOLED designs, the substrate 1002 provides structural support for the OLED pixels and circuits. In various arrangements, the substrate 1002 can comprise rigid or flexible materials as well as opaque or transparent materials, such as plastic, glass, and/or foil. As noted above, each OLED pixel or diode is formed with the anode 1004, cathode 1006 and organic layer 1010 interposed therebetween. When an appropriate electrical current is applied to the anode 1004, the cathode 1006 injects electrons and the anode 1004 injects holes. In certain arrangements, the anode 1004 and cathode 1006 are inverted; i.e., the cathode is formed on the substrate 1002 and the anode is opposingly arranged.

Interposed between the cathode 1006 and anode 1004 are one or more organic layers. More specifically, at least one emissive or light emitting layer is interposed between the cathode 1006 and anode 1004. The light emitting layer may comprise one or more light emitting organic compounds. Typically, the light emitting layer is configured to emit visible light in a single color such as blue, green, red or white. In the illustrated arrangement, one organic layer 1010 is formed between the cathode 1006 and anode 1004 and acts as a light emitting layer. Additional layers, which can be formed between the anode 1004 and cathode 1006, can include a hole transporting layer, a hole injection layer, an electron transporting layer and an electron injection layer.

Hole transporting and/or injection layers can be interposed between the light emitting layer 1010 and the anode 1004. Electron transporting and/or injecting layers can be interposed between the cathode 1006 and the light emitting layer 1010. The electron injection layer facilitates injection of electrons from the cathode 1006 toward the light emitting layer 1010 by reducing the work function for injecting electrons from the cathode 1006. Similarly, the hole injection layer facilitates injection of holes from the anode 1004 toward the light emitting layer 1010. The hole and electron transporting layers facilitate movement of the carriers injected from the respective electrodes toward the light emitting layer.

In some arrangements, a single layer may serve both electron injection and transportation functions or both hole injection and transportation functions. In some arrangements, one or more of these layers are lacking. In some arrangements, one or more organic layers are doped with one or more materials that help injection and/or transportation of the carriers. In arrangements where only one organic layer is formed between the cathode and anode, the organic layer may include not only an organic light emitting compound but also certain functional materials that help injection or transportation of carriers within that layer.

There are numerous organic materials that have been developed for use in these layers including the light emitting layer. Also, numerous other organic materials for use in these layers are being developed. In some arrangements, these organic materials may be macromolecules including oligomers and polymers. In some arrangements, the organic materials for these layers may be relatively small molecules. The skilled artisan will be able to select appropriate materials for each of these layers in view of the desired functions of the individual layers and the materials for the neighboring layers in particular designs.

In operation, an electrical circuit provides appropriate potential between the cathode 1006 and anode 1004. This results in an electrical current flowing from the anode 1004 to the cathode 1006 via the interposed organic layer(s). In one arrangement, the cathode 1006 provides electrons to the adjacent organic layer 1010. The anode 1004 injects holes to the organic layer 1010. The holes and electrons recombine in the organic layer 1010 and generate energy particles called "excitons." The excitons transfer their energy to the organic light emitting material in the organic layer 1010, and the energy is used to emit visible light from the organic light emitting material. The spectral characteristics of light generated and emitted by the OLED 1000, 1001 depend on the nature and composition of organic molecules in the organic layer(s). The composition of the one or more organic layers can be selected to suit the needs of a particular application by one of ordinary skill in the art.

OLED devices can also be categorized based on the direction of the light emission. In one type referred to as "top emission" type, OLED devices emit light and display images through the cathode or top electrode 1006. In these arrangements, the cathode 1006 is made of a material transparent or at least partially transparent with respect to visible light. In certain arrangements, to avoid losing any light that can pass through the anode or bottom electrode 1004, the anode may be made of a material substantially reflective of the visible light. A second type of OLED devices emits light through the anode or bottom electrode 1004 and is called "bottom emission" type. In the bottom emission type OLED devices, the anode 1004 is made of a material which is at least partially transparent with respect to visible light. Often, in bottom emission type OLED devices, the cathode 1006 is made of a material substantially reflective of the visible light. A third type of OLED devices emits light in two directions, e.g. through both anode 1004 and cathode 1006. Depending upon the direction(s) of the light emission, the substrate may be formed of a material which is transparent, opaque or reflective of visible light.

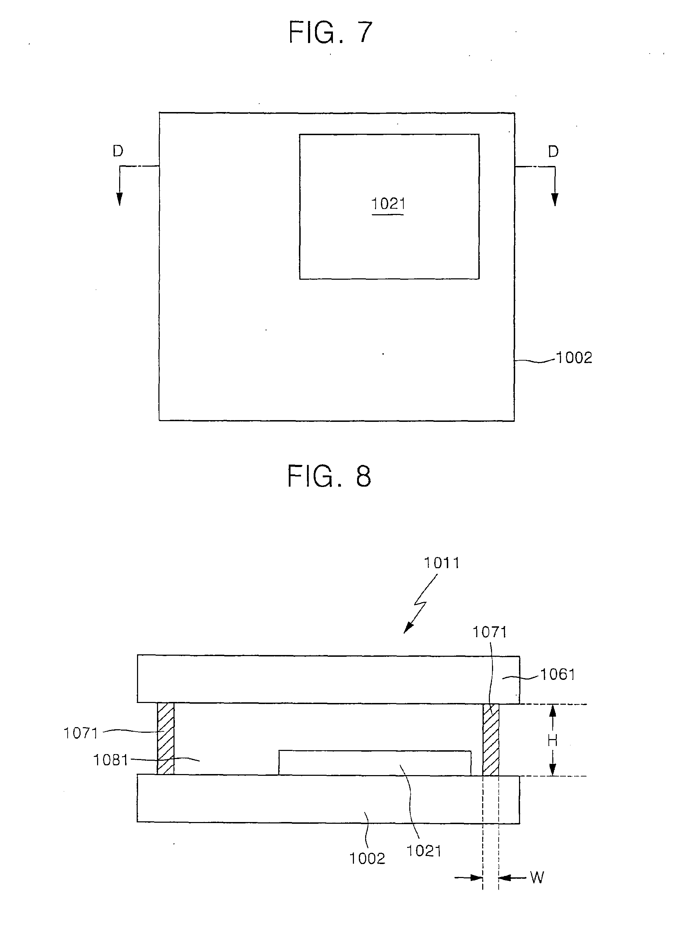

In many arrangements, an OLED pixel array 1021 comprising a plurality of organic light emitting pixels is arranged over a substrate 1002 as shown in Fig. 7. The pixels in the array 1021 are controlled to be turned on and off by a driving circuit (not shown), and the plurality of the pixels as a whole displays information or image on the array 1021. The OLED pixel array 1021 is arranged with respect to other components, such as drive and control electronics to define a display region and a non-display region. In these arrangements, the display region refers to the area of the substrate 1002 where OLED pixel array 1021 is formed. The non-display region refers to the remaining areas of the substrate 1002. The non-display region can contain logic and/or power supply circuitry. It will be understood that there will be at least portions of control/drive circuit elements arranged within the display region. For example, in PMOLEDs, conductive components will extend into the display region to provide appropriate potential to the anode and cathodes. In AMOLEDs, local driving circuits and data/scan lines coupled with the driving circuits will extend into the display region to drive and control the individual pixels of the AMOLEDs.

One design and fabrication consideration in OLED devices is that certain organic material layers of OLED devices can suffer damage or accelerated deterioration from exposure to water, oxygen or other harmful gases. Accordingly, it is generally understood that OLED devices be sealed or encapsulated to inhibit exposure to moisture and oxygen or other harmful gases found in a manufacturing or operational environment. Fig. 8 schematically illustrates a cross-section of an encapsulated OLED device 1011 having a layout of Fig. 7 and taken along the line d-d of Fig. 7. A generally planar top plate or substrate 1061 engages with a seal 1071 which further engages with a bottom plate or substrate 1002 to enclose or encapsulate the OLED pixel array 1021. In other arrangements, one or more layers are formed on the top plate 1061 or bottom plate 1002, and the seal 1071 is coupled with the bottom or top substrate 1002, 1061 via such a layer. In the illustrated arrangement, the seal 1071 extends along the periphery of the OLED pixel array 1021 or the bottom or top plate 1002, 1061.

The seal 1071 is made of a frit material as will be further discussed below. In various arrangements, the top and bottom plates 1061, 1002 comprise materials such as plastics, glass and/or metal foils which can provide a barrier to passage of oxygen and/or water to thereby protect the OLED pixel array 1021 from exposure to these substances. At least one of the top plate 1061 and the bottom plate 1002 are formed of a substantially transparent material.

To lengthen the life time of OLED devices 1011, it is generally desired that seal 1071 and the top and bottom plates 1061, 1002 provide a substantially non-permeable seal to oxygen and water vapor and provide a substantially hermetically enclosed space 1081. In certain applications, it is indicated that the seal 1071 of a frit material in combination with the top and bottom plates 1061, 1002 provide a barrier to oxygen of less than approximately 10⁻³ cc/m²-day and to water of less than 10⁻⁶ g/m²-day. Given that some oxygen and moisture can permeate into the enclosed space 1081, in some arrangements, a material that can take up oxygen and/or moisture is formed within the enclosed space 1081.

The seal 1071 has a width W, which is its thickness in a direction parallel to a surface of the top or bottom substrate 1061, 1002 as shown in Fig. 8. The width varies among arrangements and ranges from about 300 µm to about 3000 µm, optionally from about 500 µm to about 1500 µm. Also, the width may vary at different positions of the seal 1071. The width of the seal 1071 may be the largest where the seal 1071 contacts one of the bottom and top substrate 1002, 1061 or a layer formed thereon. The width may be the smallest where the seal 1071 contacts the other. The width variation in a single cross-section of the seal 1071 relates to the cross-sectional shape of the seal 1071 and other design parameters.

The seal 1071 has a height H, which is its thickness in a direction perpendicular to a surface of the top or bottom substrate 1061, 1002 as shown in Fig. 8. The height varies among arrangements and ranges from about 2 µm to about 30 µm, optionally from about 10 µm to about 15 µm. Generally, the height does not significantly vary at different positions of the seal 1071. However, in certain arrangements, the height of the seal 1071 may vary at different positions thereof.

In the illustrated arrangement, the seal 1071 has a generally rectangular cross-section. In other arrangement, however, the seal 1071 can have other various cross-sectional shapes such as a generally square cross-section, a generally trapezoidal cross-section, a cross-section with one or more rounded edges, or other configuration as indicated by the needs of a given application. To improve hermeticity, it is generally desired to increase the interfacial area where the seal 1071 directly contacts the bottom or top substrate 1002, 1061 or a layer formed thereon. In some arrangements, the shape of the seal can be designed such that the interfacial area can be increased.

The seal 1071 can be arranged immediately adjacent the OLED array 1021, and in other arrangements, the seal 1071 is spaced some distance from the OLED array 1021. In certain arrangements, the seal 1071 comprises generally linear segments that are connected together to surround the OLED array 1021. Such linear segments of the seal 1071 can extend generally parallel to respective boundaries of the OLED array 1021. In other arrangements, one or more of the linear segments of the seal 1071 are arranged in a non-parallel relationship with respective boundaries of the OLED array 1021. In yet other arrangements, at least part of the seal 1071 extends between the top plate 1061 and bottom plate 1002 in a curvilinear manner.

As noted above, in certain arrangements, the seal 1071 is formed using a frit material or simply "frit" or glass frit," which includes fine glass particles. The frit particles includes one or more of magnesium oxide (MgO), calcium oxide (CaO), barium oxide (BaO), lithium oxide (Li₂O), sodium oxide (Na₂O) potassium oxide (K₂O), boron oxide (B₂O₃), vanadium oxide (V₂O₅), zinc oxide (ZnO), tellurium oxide (TeO₂), aluminum oxide (Al₂O₃), silicon dioxide (SiO₂), lead oxide (PbO), tin oxide (SnO), phosphorous oxide (P₂O₅ ruthenium oxide (Ru₂O), rubidium oxide (Rb₂O), rhodium oxide (Rh₂O), ferrite oxide (Fe₂O₃), copper oxide (CuO), titanium oxide (TiO₂) tungsten oxide (WO₃), bismuth oxide (Bi₂O₃), antimony oxide (Sb₂O₃), lead-borate glass, tin-phosphate glass, vanadate glass, and borosilicate, etc. These particles range in size from about 2 µm to about 30 µm, optionally about 5 µm to about 10 µm, although not limited only thereto. The particles can be as large as about the distance between the top and bottom substrates 1061, 1002 or any layers formed on these substrates where the frit seal 1071 contacts.

The frit material used to form the seal 1071 can also include one or more filler or additive materials. The filler or additive materials can be provided to adjust an overall thermal expansion characteristic of the seal 1071 and/or to adjust the absorption characteristics of the seal 1071 for selected frequencies of incident radiant energy. The filler or additive material(s) can also include inversion and/or additive fillers to adjust a coefficient of thermal expansion of the frit. For example, the filler or additive materials can include transition metals, such as chromium (Cr), iron (Fe), manganese (Mn), cobalt (Co), copper (Cu), and/or vanadium. Additional materials for the filler or additives include ZnSiO₄, PbTiO₃, ZrO₂, eucryptite.

A frit material as a dry composition can contain glass particles from about 20 to 90 about wt%, and the remaining includes fillers and/or additives. In some arrangements, the frit paste contains about 10-30 wt% organic materials and about 70-90% inorganic materials. In some arrangements, the frit paste contains about 20 wt% organic materials and about 80 wt% inorganic materials. The organic materials may include about 0-30 wt% binder(s) and about 70-100 wt% solvent(s). About 10 wt% may be binder(s) and about 90 wt% may be solvent(s) among the organic materials. The inorganic materials may include about 0-10 wt% additives, about 20-40 wt% fillers and about 50-80 wt% glass powder. About 0-5 wt% may be additive(s), about 25-30 wt% is filler(s) and about 65-75 wt% may be the glass powder among the inorganic materials.

In forming a frit seal, a liquid material is added to the dry frit material to form a frit paste. Any organic or inorganic solvent with or without additives can be used as the liquid material. The solvent may include one or more organic compounds. For example, applicable organic compounds are ethyl cellulose, nitro cellulose, hydroxyl propyl cellulose, butyl carbitol acetate, terpineol, butyl cellusolve, acrylate compounds. Then, the thus formed frit paste can be applied to form a shape of the seal 1071 on the top and/or bottom plate 1061, 1002.

In one arrangement, a shape of the seal 1071 is initially formed from the frit paste and interposed between the top plate 1061 and the bottom plate 1002. The seal 1071 can in certain arrangements be pre-cured or pre-sintered to one of the top plate and bottom plate 1061, 1002. Following assembly of the top plate 1061 and the bottom plate 1002 with the seal 1071 interposed therebetween, portions of the seal 1071 are selectively heated such that the frit material forming the seal 1071 at least partially melts. The seal 1071 is then allowed to resolidify to form a secure joint between the top plate 1061 and the bottom plate 1002 to thereby inhibit exposure of the enclosed OLED pixel array 1021 to oxygen or water.

The selective heating of the frit seal is carried out by irradiation of light, such as a laser or directed infrared lamp. As previously noted, the frit material forming the seal 1071 can be combined with one or more additives or filler such as species selected for improved absorption of the irradiated light to facilitate heating and melting of the frit material to form the seal 1071.

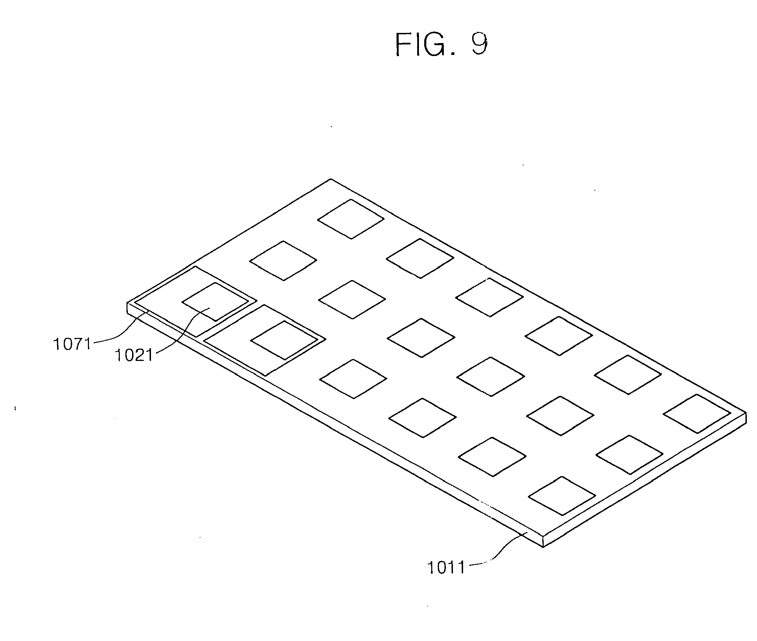

OLED devices 1011 are often mass produced. In an arrangement illustrated in Fig. 9, a plurality of separate OLED arrays 1021 is formed on a common bottom substrate 1101. In the arrangement embodiment, each OLED array 1021 is surrounded by a shaped frit to form the seal 1071. A common top substrate (not shown) is placed over the common bottom substrate 1101 and the structures formed thereon such that the OLED arrays 1021 and the shaped frit paste are interposed between the common bottom substrate 1101 and the common top substrate. The OLED arrays 1021 are encapsulated and sealed, such as via the previously described enclosure process for a single OLED display device. The resulting product includes a plurality of OLED devices kept together by the common bottom and top substrates. Then, the resulting product is cut into a plurality of pieces, each of which constitutes an OLED device 1011 of Fig. 8. In certain arrangements, the individual OLED devices 1011 then further undergo additional packaging operations to further improve the sealing formed by the frit seal 1071 and the top and bottom substrates 1061, 1002.

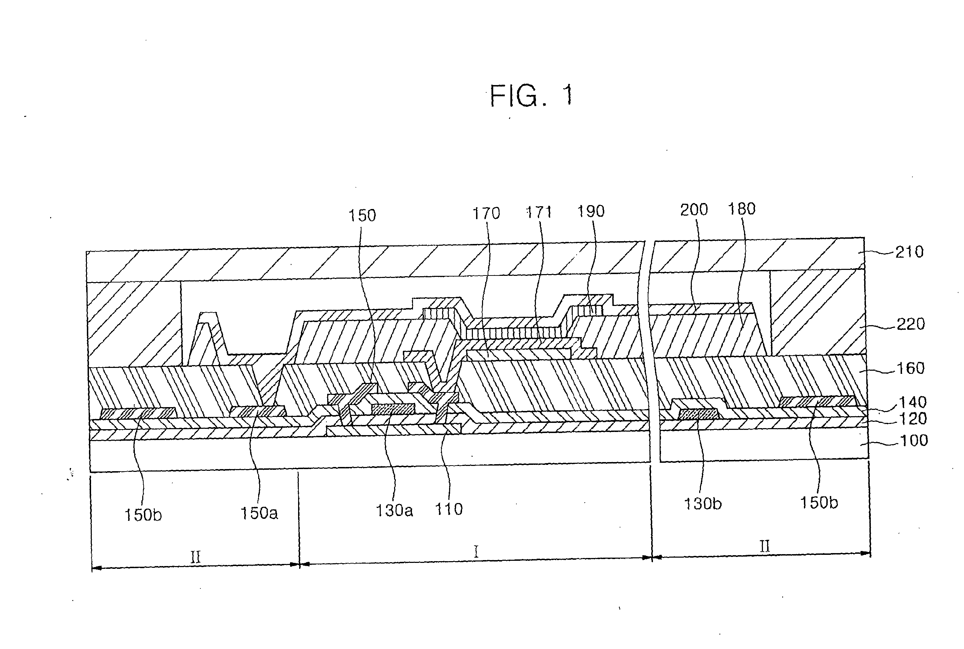

FIG. 1 is a cross-sectional view of an OLED. Referring to FIG. 1, a semiconductor layer 110, a gate insulating layer 120, a gate electrode 130a, a scan driver 130b, an interlayer insulating layer 140 and source and drain electrodes 150 are disposed on a substrate 100 including a pixel region (I) and a non-pixel region (II). And, a common power supply line 150b and a second electrode power supply line 150a, which are composed of source and drain interconnections, are further disposed on the substrate 100.

A planarization layer 160 is disposed on the entire surface of the substrate 100. The planarization layer 160 is formed of an organic material, for example, acryl resin or polyimide resin.

The planarization layer 160 includes via holes exposing the second electrode power supply line 150a and the source and drain electrodes 150.

A first electrode 171 having a reflection layer 170 is disposed on the substrate 100, and a pixel defining layer 180 is disposed on the entire surface of the substrate 100.

An organic layer 190 including at least an emissive layer is disposed on the first electrode 171, and a second electrode 200 is disposed thereon. An encapsulation substrate 210 is disposed opposite to the substrate 100. The substrate 100 and the encapsulation substrate 210 are sealed with a glass frit 220, and thus an OLED is completed.

However, in some OLEDs, an organic planarization layer formed of an organic material is disposed under the glass frit encapsulating the substrate and thus can be damaged by heat during laser radiation of the glass frit.

As a result, adhesion at an interface between the glass frit and the organic planarization layer deteriorates.

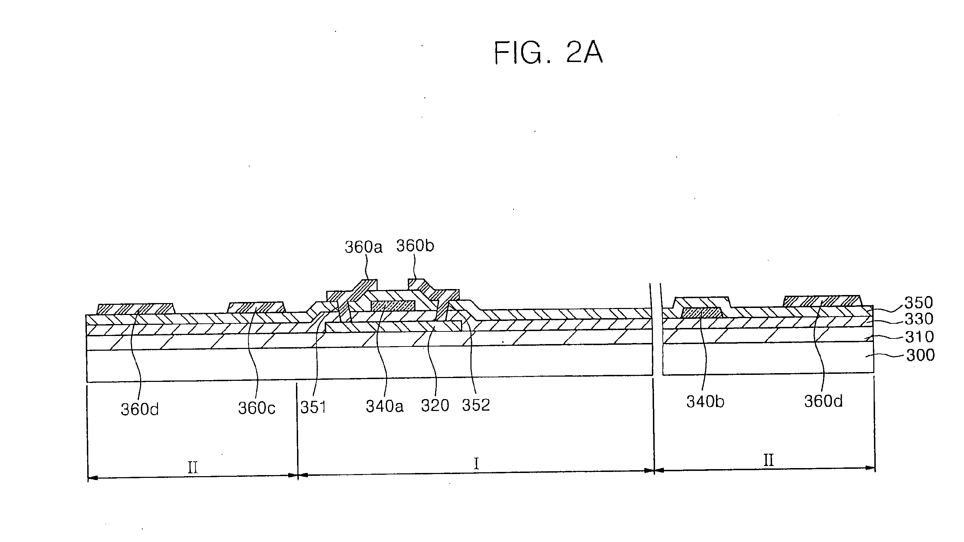

FIGS. 2A to 2D are cross-sectional views of an OLED according to a first embodiment of the invention.

Referring to FIG. 2A, a substrate 300 including a pixel region (I) and a non-pixel region (II) is provided. The substrate 300 may be an insulating glass substrate, a plastic substrate or a conductive substrate.

A buffer layer 310 is formed on the entire surface of the substrate 300. The buffer layer 310 may be a silicon oxide layer, a silicon nitride layer or a multilayer thereof. And, the buffer layer 310 serves as a protection layer which prevents impurities from diffusing from the substrate.

A semiconductor layer 320 is formed on the buffer layer 310 in the pixel region (I). The semiconductor layer 320 may be an amorphous silicon layer or a poly crystalline silicon layer formed by crystallizing the amorphous silicon layer. A gate insulating layer 330 is formed on the entire surface of the substrate 300. The gate insulating layer 330 may be a silicon oxide layer, a silicon nitride layer or a multilayer thereof.

A gate electrode 340a is formed on the gate insulating layer 330 corresponding to a part of the semiconductor layer 320. The gate electrode 340a may be formed of Al, Cu or Cr.

An interlayer insulating layer 350 is formed on the entire surface of the substrate 300, and may be a silicon oxide layer, a silicon nitride layer or a multilayer thereof. The interlayer insulating layer 350 and the gate insulating layer 330 in the pixel region (I) are etched to form contact holes 351 and 352 exposing the semiconductor layer 320.

Then, source and drain electrodes 360a and 360b are formed on the interlayer insulating layer 350 in the pixel region (I). The source and drain electrodes 360a and 360b may be formed of at least one selected from the group consisting of Mo, Cr, Al, Ti, Au, Pd and Ag. Also, the source and drain electrodes 360a and 360b are connected with the semiconductor layer 320 through the contact holes 351 and 352.

Here, when the gate electrode 340a is formed, a scan driver 340b may be simultaneously formed in the non-pixel region (II).

While a thin film transistor having a top gate structure is formed in the exemplary embodiment, a thin film transistor having a bottom gate structure in which a gate electrode is disposed under a semiconductor layer may be formed in an alternative embodiment.

Also, in this embodiment, during formation of the source and drain electrodes, a metal interconnection 360d may be simultaneously formed. The metal interconnection may serve as a common power supply line, and here, a second electrode power supply line 360c may also be formed. Alternatively, when the gate electrode or the first electrode is formed, a metal interconnection may be formed at the same time.

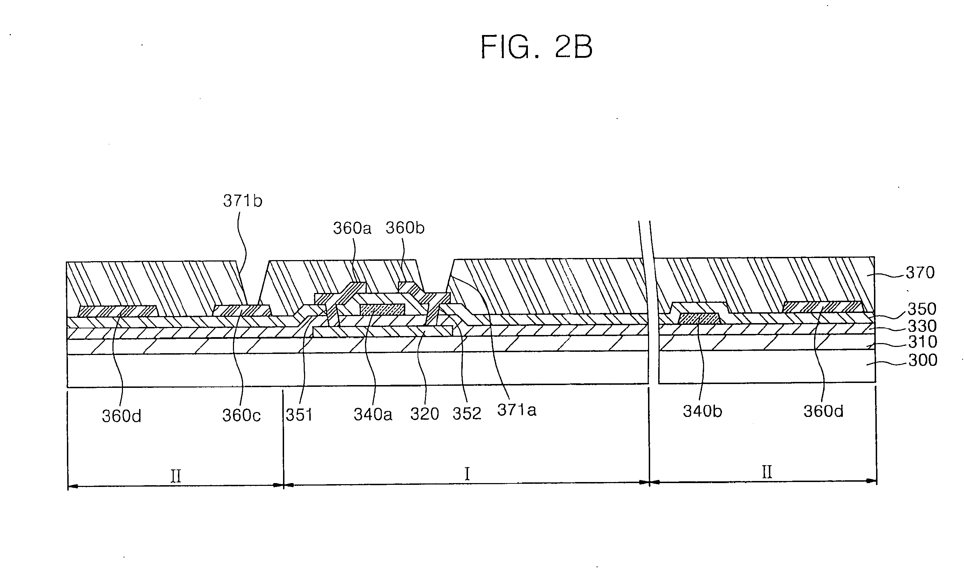

Referring to FIG. 2B, an inorganic planarization layer 370 is formed on the entire surface of the substrate 300. The inorganic planarization layer 370 is at least one selected from the group consisting of a silicon oxide layer, a silicon nitride layer, and spin on glass (SOG).

Here, the inorganic planarization layer 370 is formed to a thickness of 1 to 5 µm to enhance a planarization characteristic. When the inorganic planarization layer 370 is less than 1 µm thick, its planarization characteristic is not good enough, and when it is more than 5 µm thick, the device becomes thicker.

Also, the inorganic planarization layer 370 in the pixel region (I) is etched to form a via hole 371a exposing either one of the source and drain electrodes 360a and 360b, and the inorganic planarization layer 370 in the non-pixel region (II) is etched to partially expose the second electrode power supply line 360c.

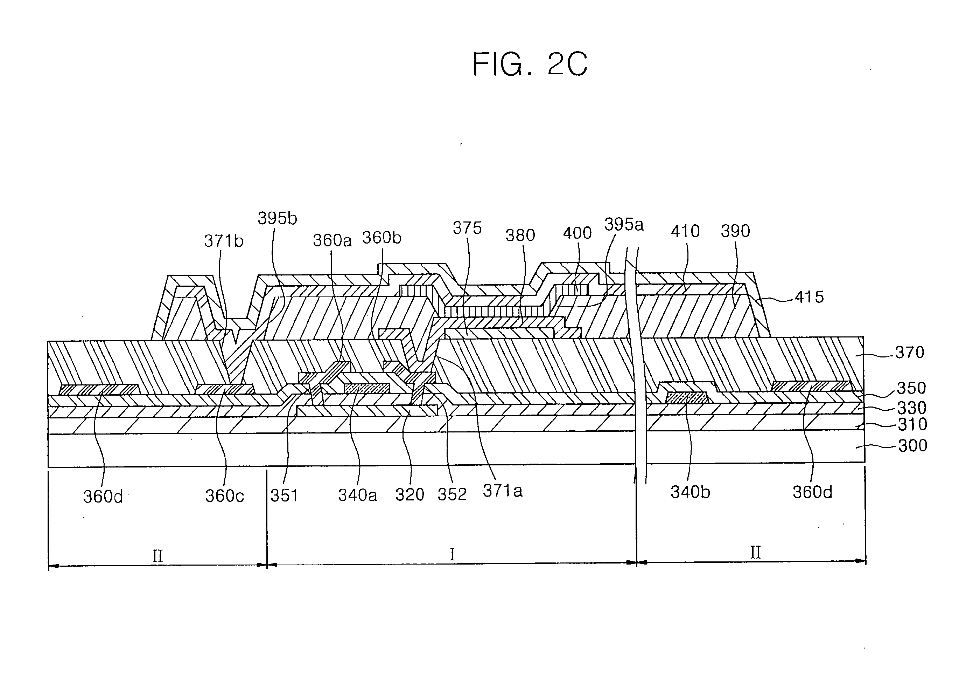

Referring to FIG. 2C, a first electrode 380 having a reflection layer 375 is formed on the inorganic planarization layer 370 in the pixel region (I). The first electrode 380 is disposed at the bottom of the via hole 371 and contacts either one of the exposed source and drain electrodes 360a and 360b, and then extends to the inorganic planarization layer 370. The first electrode 380 may be formed of indium tin oxide (ITO) or indium zinc oxide (IZO).

A pixel defining layer 390 is formed on the entire surface of the substrate 300 including the first electrode 380 to a thickness sufficient to fill the via hole 371 on which the first electrode 380 is disposed. The pixel defining layer 390 may be an organic or inorganic layer, but is preferably an organic layer. More preferably, the pixel defining layer 390 is made from one of BCB (benzocyclobutene), acryl polymer, and polyimide. The pixel defining layer 390 has excellent flowability, and thus can be evenly formed on the entire surface of the substrate 300.

The pixel defining layer 390 in the pixel region (I) is etched to form an opening 395a exposing the first electrode 380, and the pixel defining layer 390 in the non-pixel region (II) is etched to expose the second electrode power supply line 360c.

And, the pixel defining layer 390 of the edge of the substrate 300 in the non-pixel region (II) which will be encapsulated later is etched to improve adhesion between the glass frit and the inorganic planarization layer 370.

An organic layer 400 is formed on the first electrode 380 exposed through the opening 395a. The organic layer 400 includes at least an emissive layer, and may further include at least one of a hole injection layer, a hole transport layer, an electron transport layer, and an electron injection layer.

A second electrode 410 is formed on the entire surface of the substrate 300. The second electrode 410 may be formed of any one of Mg, Ag, Al, Ca and an alloy thereof.

Here, the second electrode 410 of the edge of the substrate 300 in the non-pixel region (II) which will be encapsulated later is also etched to improve adhesion between the glass frit and the inorganic planarization layer 370.

Here, a protection layer 415 may be further formed to entirely cover the second electrode 410. In a top emission structure, the protection layer 415 serves to protect the second electrode 410 which is very thin when used as a transparent electrode, so it can be easily degraded.

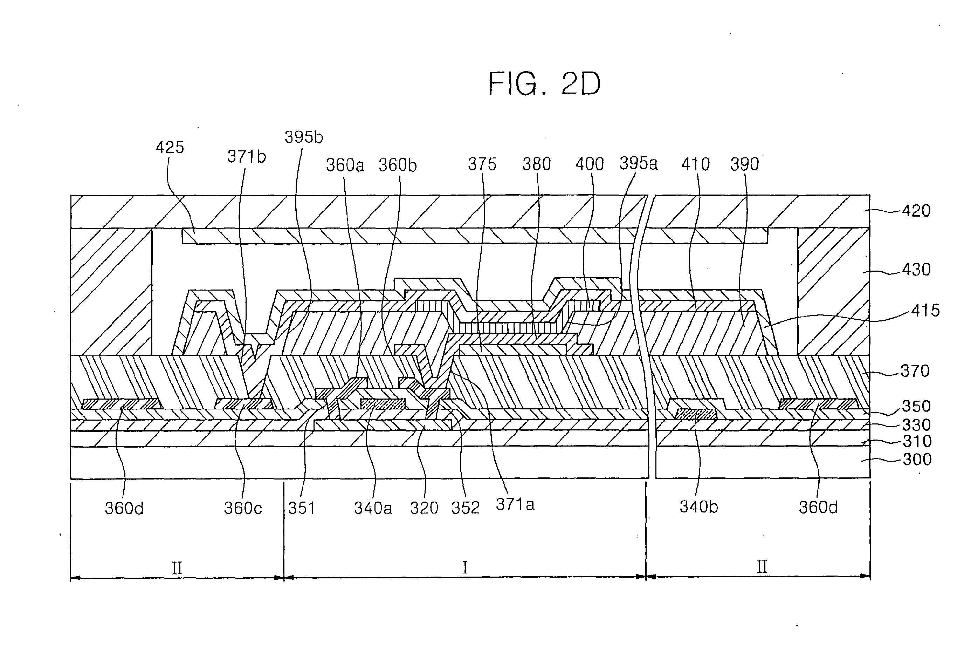

Referring to FIG. 2D, an encapsulation substrate 420 facing the substrate 300 is provided. The encapsulation substrate 420 may be formed of an etched or non-etched insulating glass.

Then, an absorbent layer 425 is formed on the encapsulation substrate 420. The absorbent 420 may be a transparent absorbent, or an opaque absorbent, for example, a getter.

Here, the transparent absorbent material may be formed on the entire surface of the encapsulation substrate, and may be at least one selected from the group consisting of alkali-metal oxide, alkaline earth metal oxide, metal halide, metal sulfate, metal perchlorate, and phosphorus pentoxide (P₂O₅), which have an average diameter of 100 nm or less, and particularly 20 to 100 nm.

A glass frit 430 is formed along edges of the encapsulation substrate 420. That is, the glass frit 430 is applied along edges of the encapsulation substrate 420 opposite to the substrate 300.

While the glass frit is applied along edges of the encapsulation substrate in the exemplary embodiment, it may alternatively be formed on the inorganic planarization layer in the non-pixel region (II) of the substrate.

Here, the glass frit 430 may be formed of one or more materials selected from the group consisting of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂) aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borosilicate, and may be applied by dispensing or screen printing.

The substrate 300 and the encapsulation substrate 420 are aligned and then adhered. Here, the glass frit 430 contacts the inorganic planarization layer 370 on the substrate 300 in the non-pixel region (II).

While the glass frit 430 is disposed on the inorganic planarization layer 370 in this embodiment, it may be formed on the gate insulating layer 330 or the interlayer insulating layer 350 which is formed of an inorganic material in an alternative embodiment, so as to prevent deterioration of adhesion during a subsequent laser radiation process performed on the glass frit 430.

The glass frit 430 is melted by laser and then solidified to be adhered to the substrate and the encapsulation substrate, and thus the OLED according to the first embodiment of the invention is manufactured.

Usually, the organic planarization layer is disposed under the glass frit, and thus is damaged by heat during laser radiation. Accordingly, adhesion between the glass frit and the organic planarization layer deteriorates and the glass frit is delaminated from the organic planarization layer.

However, since the inorganic layer is not damaged by high heat of laser when formed under the glass frit as described above, the glass frit is not delaminated due to low adhesion between the glass frit and the inorganic layer.

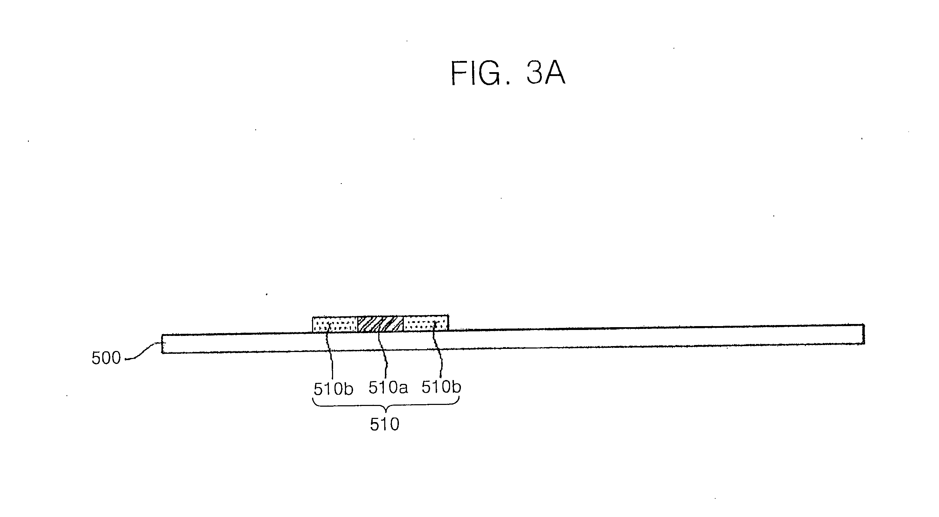

FIGS. 3A to 3G are cross-sectional views of an OLED according to a second embodiment of the invention.

Referring to FIG. 3A, a semiconductor layer 510 is formed on one region of a deposition substrate 500. The semiconductor layer 510 is divided into a channel layer 510a and source and drain regions 510b by performing an ion-doping process in a predetermined region.

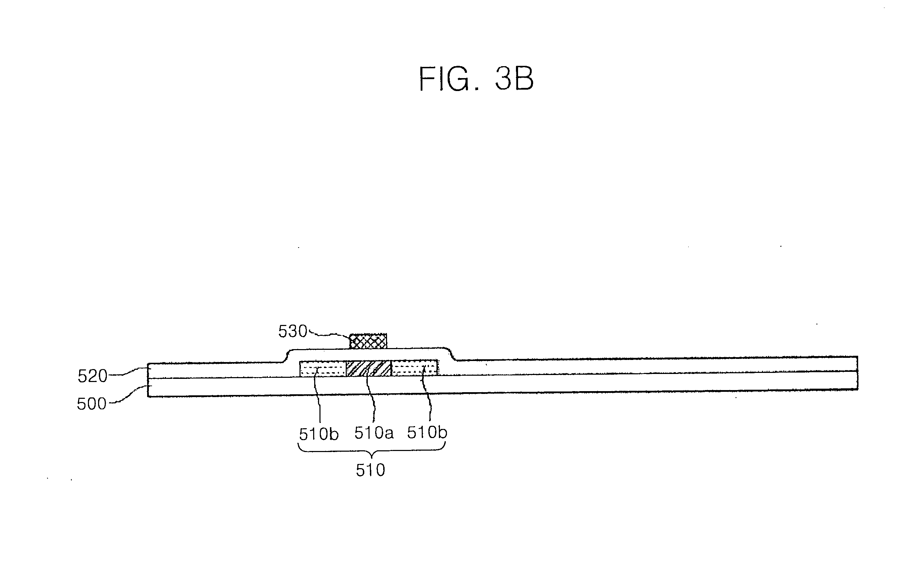

Referring to FIG. 3B, a gate insulating layer 520 is formed on the entire surface of the deposition substrate 500 including the semiconductor layer 510. And, a gate electrode 530 is formed in a region corresponding to the channel layer 510a of the gate insulating layer 520.

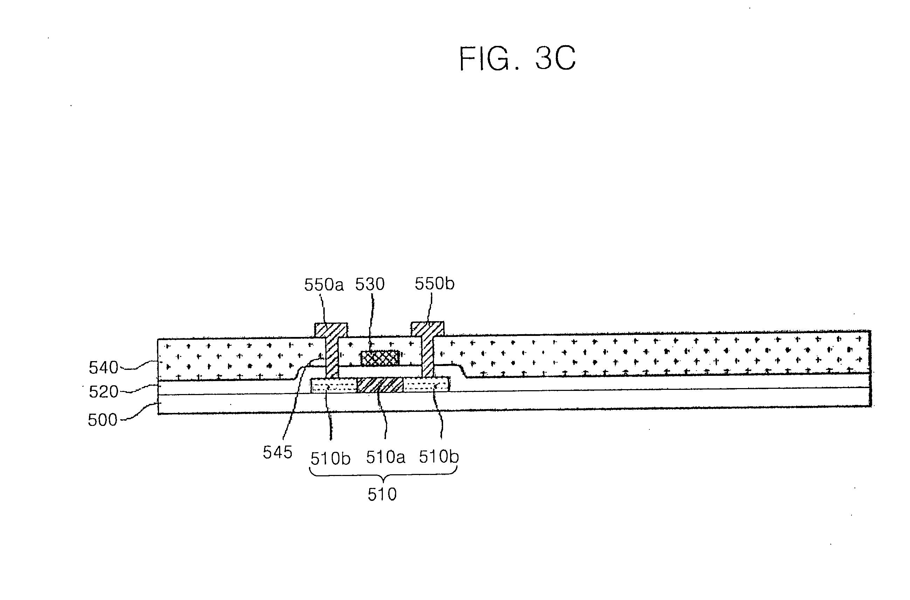

Referring to FIG. 3C, an interlayer insulating layer 540 is formed on the gate insulating layer 520 including the gate electrode 530. Then, a contact hole 545 is formed in at least one region of the gate insulating layer 520 and the interlayer insulating layer 540. Source and drain electrodes 550a and 550b connected with the source and drain regions 510b through the contact hole 545 are formed on the interlayer insulating layer 540.

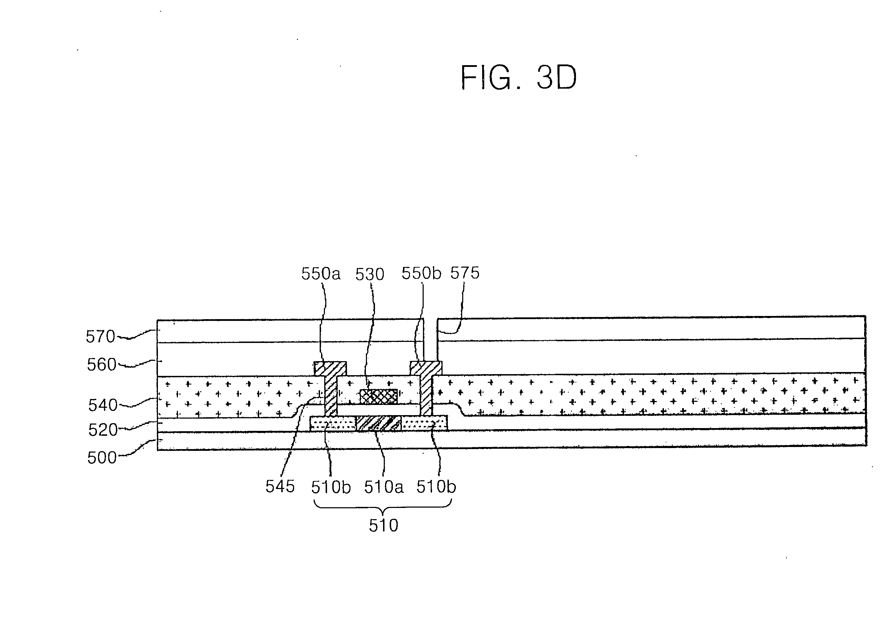

Referring to FIG. 3D, an inorganic layer 560 is formed on an interlayer insulating layer 540 including the source and drain electrodes 550a and 550b. The inorganic layer 560 may be at least one of a silicon nitride (SiNₓ) layer and a silicon oxide (SiOₓ) layer. The inorganic layer 560 serves to inhibit diffusion of moisture or impurities from the outside and protect the source and drain electrodes 550a and 550b, etc.

An organic planarization layer 570 is formed on the inorganic layer 560, and a photoresist pattern (not illustrated) is formed over the organic planarization layer 570. Then, the inorganic layer 560 and the organic planarization layer 570 are etched using the photoresist pattern as a mask to form a via hole 575 in one region of the inorganic layer 560 and the organic planarization layer 570. Here, a first electrode 580 of an organic light emitting diode 580, 600 and 610 is connected with one of the source and drain electrodes 550a and 550b through the via hole 575. The via hole 575 may be formed by wet etching or dry etching, and preferably dry etching. The dry etch process may employ a commonly used technique such as ion beam etching, RF sputtering etching, or reactive ion etching (RIE). Meanwhile, the organic planarization layer 570 may be formed of at least one selected from the group consisting of polyacryl resin, epoxy resin, phenol resin, polyamide resin, polyimide resin, unsaturated polyester resin, polyphenylene ether resin, polyphenylene sulfide resin, and benzocyclobutene.

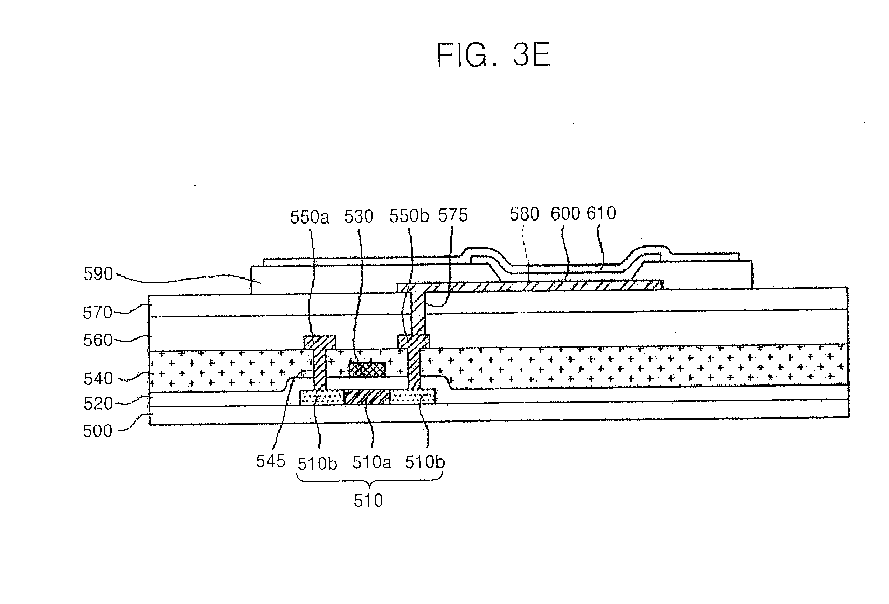

Referring to FIG. 3E, the first electrode 580 of the organic light emitting diode 580, 600 and 610 is formed in one region of the organic planarization layer 570. Then, a pixel defining layer 590 including an opening (not illustrated) exposing one region of the first electrode 580 is formed on the organic planarization layer 570 including the first electrode 580. And, an organic layer 600 is formed on the opening of the pixel defining layer 590. A second electrode 610 is formed on the pixel defining layer 590 including the organic layer 600.

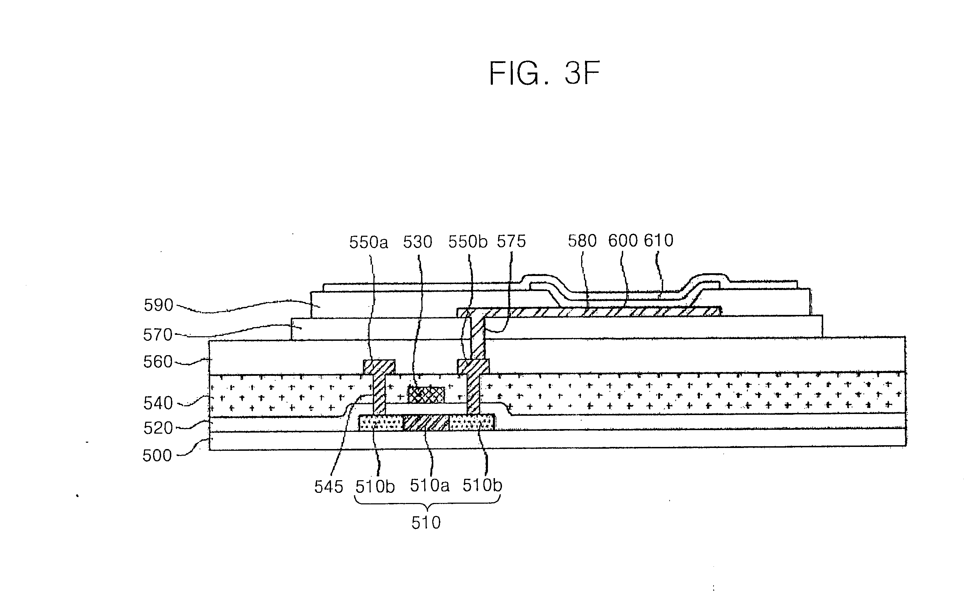

Referring to FIG. 3F, a region of the organic planarization layer 570 in which the thin film transistor 510, 530, 550a and 550b and the organic light emitting diode 580, 600 and 610 are not formed, that is, a region to which a frit 620 will be applied, is etched. In other words, the frit 620 contacts the inorganic layer formed under the organic planarization layer 570 directly, not the organic layer, by etching the organic planarization layer 570 which is the topmost layer. Accordingly, the inorganic layer which is insensitive to heat such as generated by laser radiation contacts the frit 620 directly, and thus the inorganic layer 560 is not damaged in the subsequent thermal treatment of the frit 620. Thus, an adhesion characteristic between the substrate 500 and an encapsulation substrate 630 may be improved by the frit 620. Meanwhile, the organic planarization layer 570 may be etched by dry etching. The dry etch process may employ a commonly used technique such as ion beam etching, RF sputtering etching, or reactive ion etching (RIE).

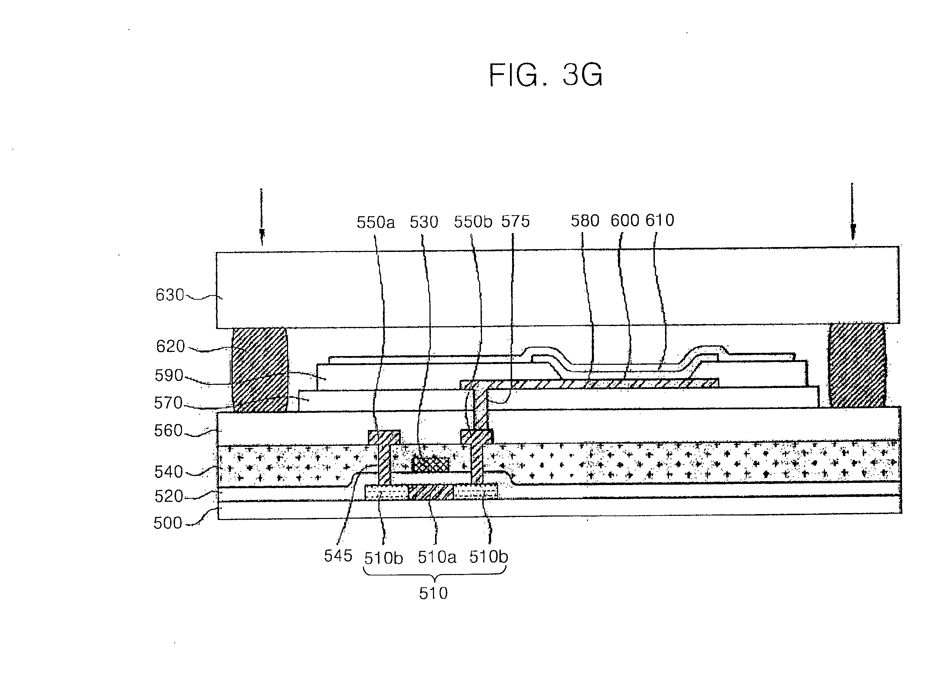

Referring to FIG. 3G, the encapsulation substrate 630 to which the frit 620 is applied along edges thereof is arranged opposite to the substrate 500. The encapsulation substrate 630 is then adhered to the substrate 500, and thus predetermined structures formed on the substrate 500 are encapsulated by the encapsulation substrate 630 to be protected from outside oxygen, hydride and moisture. Here, the encapsulation substrate 630 is not restricted to a particular material, but may be formed of at least one material selected from the group consisting of silicon oxide (SiO₂), silicon nitride (SiNₓ), and silicon oxynitride (SiOₓN_{y}).

The frit 620 is disposed between any one of regions that do not have the organic light emitting diode 580, 600 and 610, i.e., a non-pixel region (not illustrated), and the encapsulation substrate 630. Here, the frit 620 is formed to directly contact the inorganic layer 560 of the substrate 500, and includes a filler for adjusting a coefficient of thermal expansion and an absorbent absorbing laser light or infrared rays. And, a frit that has the form of glass powder is formed by abruptly reducing the temperature of glass. In general, a frit 620 containing oxide powder is used. When an organic material is added to the frit containing oxide powder, the frit becomes a gel-type paste. The frit 620 according to this embodiment includes main materials such as SiO₂ a laser or infrared absorbent such as V₂0₅, an organic binder, a filler for reducing a coefficient of thermal expansion, etc. The gel-type paste is applied onto the encapsulation substrate 630 along a sealing line. Then, a thermal treatment process is performed on the frit 620 causing an organic material to fly off into the air, and the gel-type paste is hardened to form a glass frit in a solid state. Here, transformation of the frit may be performed at a temperature of 300 to 700 °C.

After the encapsulation substrate 630 is aligned on the substrate 500, between which the frit 620 is disposed, laser or infrared radiation is applied to the frit 620 to melt it. The substrate 500 and the encapsulation substrate 630 are sealed with the melted frit 620.

As such, in the OLED according to the second embodiment of the invention, the frit is formed in direct contact with the inorganic layer, not the organic layer, and thus adhesion between the substrate and the encapsulation substrate may be improved. As a result, the OLED may be effectively sealed to prevent penetration of hydrogen, oxygen and moisture, and thus increase its lifespan and luminous efficiency.

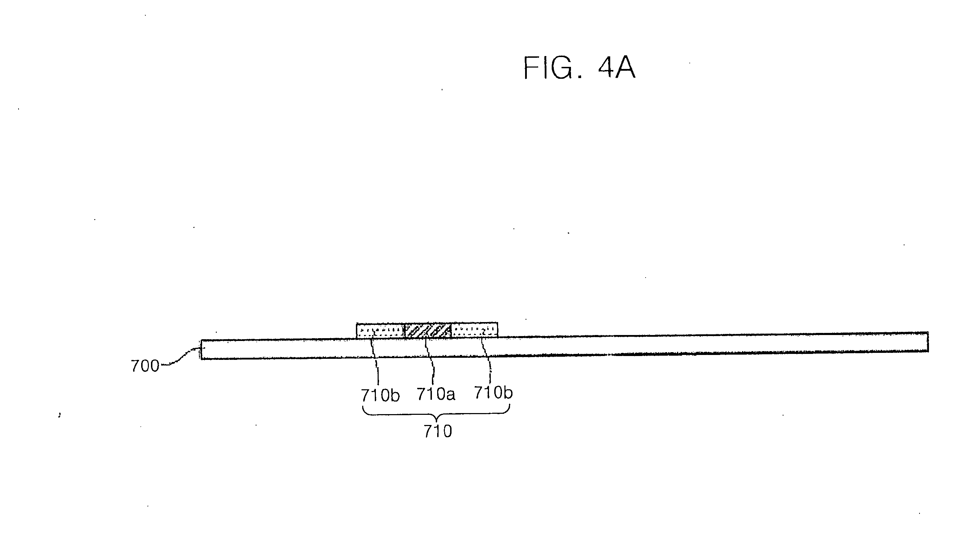

FIGS. 4A to 4F are cross-sectional views of an OLED according to a third exemplary embodiment of the invention.

Referring to FIG. 4A, a semiconductor layer 710 is formed in one region of a deposition substrate 700. The semiconductor layer 710 is separated into a channel layer 710a and source and drain regions 710b by ion doping.

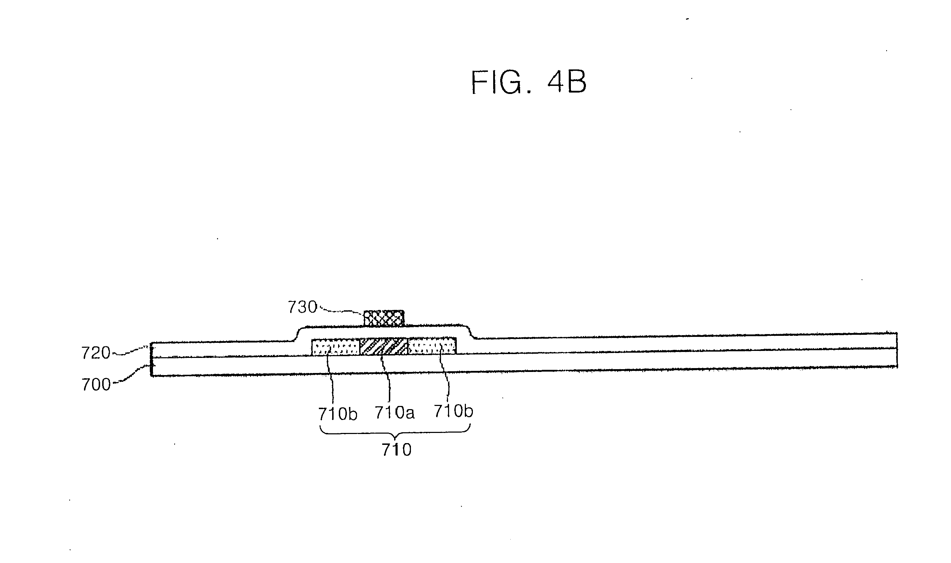

Referring to FIG. 4B, a gate insulating layer 720 is formed in one region of the deposition substrate 700 including the semiconductor layer 710. And, a gate electrode 730 is formed in a region corresponding to the channel region 710a of the gate insulating layer 720.

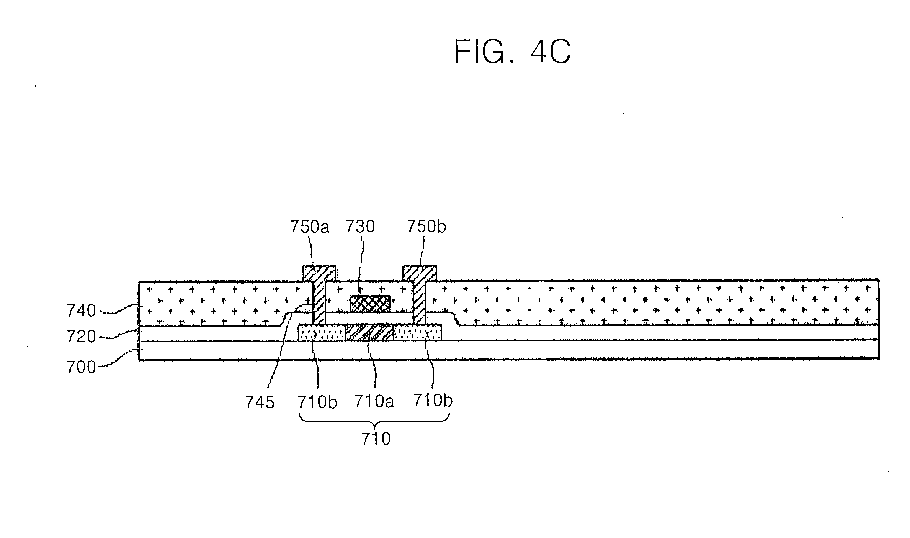

Then, referring to FIG. 4C, an interlayer insulating layer 740 is formed on the gate insulating layer 720 including the gate electrode 730. A contact hole 745 is formed in at least one region of the gate insulating layer 720 and the interlayer insulating layer 740. Source and drain electrodes 750a and 750b connected with the source and drain regions 710b through the contact hole 745 are formed on the interlayer insulating layer 740.

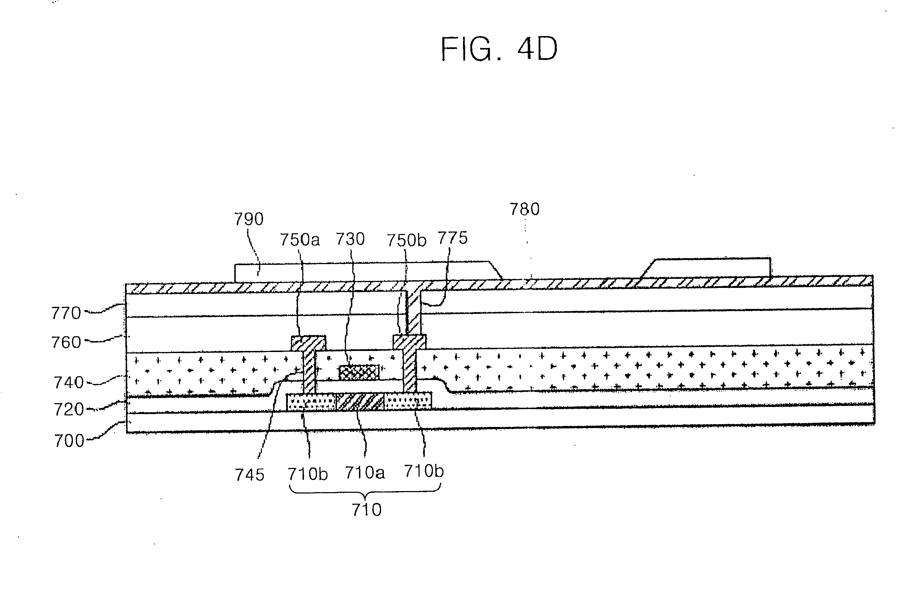

Referring to FIG. 4D, an inorganic layer 760 is formed on the source and drain electrodes 750a and 750b and the interlayer insulating layer 740. The inorganic layer 760 may be at least one of a silicon nitride (SiNₓ) layer and a silicon oxide (SiOₓ) layer. The inorganic layer 760 serves to inhibit diffusion of moisture or impurities from the outside and to protect the source and drain electrodes 750a and 750b.

An organic planarization layer 770 is formed on the inorganic layer 760. And, after a photoresist pattern (not illustrated) is formed over the organic planarization layer 770, the organic planarization layer 770 is etched using the photoresist pattern to form a via hole 775 in one region of the inorganic layer 760 and the organic planarization layer 770. Here, a first electrode 780 of an organic light emitting diode 780, 800 and 810 is electrically connected with one of the source and drain electrodes 750a and 750b through the via hole 775. The via hole 775 is formed by wet etching or dry etching, but preferably dry etching. The dry etch process may employ a commonly used technique such as ion beam etching, RF sputtering etching, or reactive ion etching (RIE). Meanwhile, the organic planarization layer 770 may be formed of at least one selected from the group consisting of polyacryl resin, epoxy resin, phenol resin, polyamide resin, polyimide resin, unsaturated polyester resin, polyphenylene ether resin, polyphenylene sulfide resin, and benzocyclobutene.

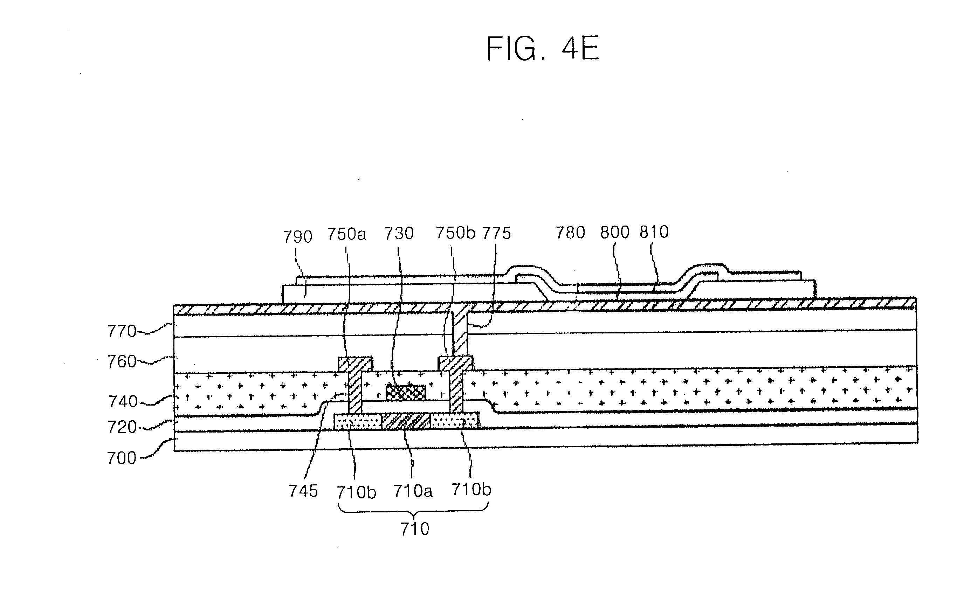

Referring to FIG. 4E, the first electrode 780 of the organic light emitting diode 780, 800 and 810 is formed in one region of the organic planarization layer 770. Here, the first electrode 780 is an anode and is formed of an inorganic material. That is, the first electrode 780 serves to improve adhesion to a frit 820 which will be described later and serves as an anode at the same time. The first electrode 780 may be formed of at least one selected from the group consisting of Al, MoW, Mo, Cu, Ag, an Al alloy, an Ag alloy, ITO, IZO and a semitransparent metal. Then, a pixel defining layer 790 including an opening (not illustrated) exposing one region of the first electrode 780 is formed on the organic planarization layer 770 including the first electrode 780. And, an organic layer 800 is formed on the opening of the pixel defining layer 790, and a second electrode 810 is formed on the pixel defining layer 790 including the organic layer 800.

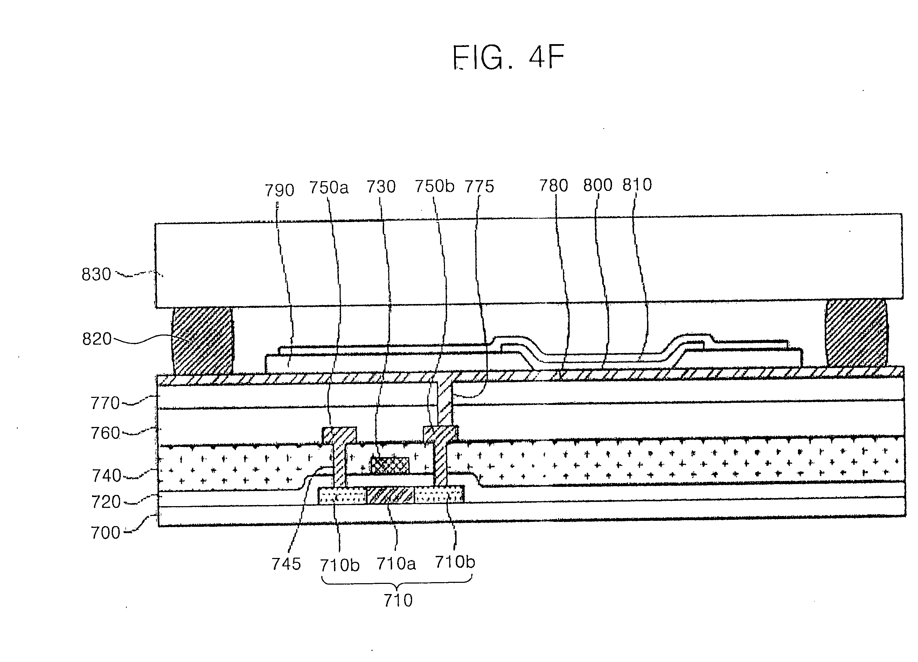

Referring to FIG. 4F, an encapsulation substrate 830 to which a frit 820 is applied along edges is arranged opposite to the substrate 700. The encapsulation substrate 830 is adhered to the substrate 700, and thus predetermined structures formed on the substrate 700 are protected by the encapsulation substrate 830 from outside oxygen and moisture. Here, the encapsulation substrate 830 is not restricted to certain materials but may be formed of at least one selected from the group consisting of silicon oxide (SiO₂), silicon nitride (SiNₓ) and silicon oxynitride (SiOₓN_{y}).

The frit 820 is disposed between a non-pixel region (not illustrated), one of regions in which the organic light emitting diode 780, 800 and 810 is not formed, and the encapsulation substrate 830. That is, the frit 820 is formed in direct contact with the first electrode 780 formed of an inorganic layer. Here, the frit 820 includes a filler for adjusting a coefficient of thermal expansion, and an absorbent absorbing laser or infrared radiation. Meanwhile, when the temperature of a glass material abruptly drops, a glass powder-type frit is formed. In general, the frit 820 includes oxide powder. And, an organic material is added to the frit 820 containing oxide powder, which becomes a gel-type paste. The frit 820 according to the exemplary embodiment is composed of main materials such as SiO₂ a laser or infrared absorbent such as V₂0₅, an organic binder, a filler for reducing a coefficient of thermal expansion, etc. The gel-type paste is applied along a sealing line of the encapsulation substrate 830. After that, when the frit 820 is thermally treated at a predetermined temperature, an organic material flies off into the air, and the gel-type paste is hardened to form a glass frit in a solid state. Here, the frit may be plasticized at a temperature of 300 to 700 °C.

Then, after the encapsulation substrate 830 is aligned on the substrate 700, on which the frit is disposed, thermal treatment with laser or infrared radiation is performed on the frit 820 to melt the frit 820. And thus, the substrate 700 and the encapsulation substrate 830 are sealed.

In this embodiment, the first electrode 780 is formed of an inorganic layer and directly contacts the frit 820. However, in an alternative embodiment, an inorganic layer (not illustrated) may be further formed between the organic planarization layer 770 and the first electrode 780 to directly contact the inorganic layer on which the frit 820 is not illustrated. The inorganic layer may be at least one of a silicon nitride (SiNₓ) layer and a silicon oxide (SiOₓ) layer. That is, the first electrode 780 may be formed of an inorganic layer, and another inorganic layer may be included in addition to the first electrode 780.

As such, in the OLED according to the third embodiment of the invention, the frit is formed in direct contact with the inorganic layer, not the organic layer, and thus adhesion between the substrate and the encapsulation substrate may be improved. As a result, the OLED may be more effectively sealed, and inhibit penetration of hydrogen, oxygen and moisture, thus increasing its lifespan and luminous efficiency.

Consequently, in an OLED and a method of fabricating the same according to an embodiment of the invention, a frit is formed to directly contact an inorganic layer, thereby improving adhesion between a substrate and an encapsulation substrate. Accordingly, the OLED may be more effectively sealed, and improve its lifespan and luminous efficiency by preventing penetration of oxygen and moisture.

Although the invention has been described with reference to certain embodiments thereof, it will be understood by those skilled in the art that a variety of modifications may be made to the described embodiments without departing from the scope of the invention as defined by the appended claims.

## Claims

1. An organic light emitting display device comprising:
a first substrate;
an second substrate;
an integrated structure formed on the first substrate, wherein the integrated structure comprises a non-conductive inorganic material layer and an array of organic light emitting pixels formed over the non-conductive inorganic material layer; and
a frit seal interposed between and interconnecting the first and second substrates while surrounding the array, the frit seal having a first surface facing the first substrate and a second surface facing the second substrate, wherein the second surface contacts the non-conductive inorganic material layer.

2. A device according to Claim 1, wherein substantially the entirety of the first surface of the frit seal contacts the non-conductive inorganic material layer.

3. A device according to Claim 1 or 2, wherein substantially the entirety of the first surface of the frit seal is fixed to the non-conductive inorganic material layer.

4. A device according to any one of Claims 1 to 3, wherein the array of organic light emitting pixels is provided between the non-conductive inorganic material layer and the second substrate.

5. A device according to any one of Claims 1 to 4, wherein the array of organic light emitting pixels comprises a first electrode, a second electrode, and an organic light emitting layer interposed between the first and second electrodes.

6. A device according to any one of Claims 1 to 5, wherein the integrated structure further comprises an array of thin film transistors, wherein the non-conductive inorganic material layer is interposed between the array of organic light emitting pixels and the array of thin film transistors, and wherein the thin film transistor is disposed between the non-conductive inorganic material layer and the first substrate.

7. A device according to Claim 6, wherein the non-conductive inorganic material layer comprises a plurality of via holes, through which electrically conductive connections are formed so as to interconnect the array of organic light emitting pixels and the array of thin film transistors.

8. A device according to any one of Claims 1 to 7, wherein the non-conductive inorganic material layer has a thickness from about 1 to about 5 (µm in thickness.

9. A device according to any one of Claims 1 to 8, wherein the integrated structure further comprises a non-conductive organic material layer substantially parallel to the non-conductive inorganic material layer, wherein the non-conductive organic material layer is formed between the non-conductive inorganic material layer and the array of organic light emitting pixels.

10. A device according to Claim 9, wherein the non-conductive organic material layer does not contact the frit seal.

11. A device according to Claim 9 or 10, wherein the integrated structure further comprises an array of thin film transistors, wherein the non-conductive inorganic material layer is interposed between the array of organic light emitting pixels and the array of thin film transistors, and wherein the thin film transistor is disposed between the non-conductive inorganic material layer and the first substrate.

12. A device according to Claim 11, wherein the non-conductive inorganic material layer comprises a plurality of via holes, through which electrically conductive connectors are formed so as to interconnect the array of organic light emitting pixels and the array of thin film transistors.

13. A device according to any one of Claims 9 to 12, wherein the non-conductive organic material layer comprises at least one material selected from the group consisting of polyacryl resin, epoxy resin, phenol resin, polyamide resin, polyimide resin, unsaturated polyester resin, polyphenylene ether resin, polyphenylene sulfide resin, and benzocyclobutene.

14. A device according to any one of Claims 1 to 13, wherein the non-conductive inorganic material layer comprises at least one of silicon nitride (SiNₓ), silicon oxide (SiOₓ), and spin on glass (SOG).

15. A device according to Claim 14, wherein the non-conductive inorganic material layer consists essentially of one or more inorganic materials.

16. A device according to any one of Claims 1 to 15, wherein the frit seal comprises one or more materials selected from the group consisting of magnesium oxide (MgO), calcium oxide (CaO), barium oxide (BaO), lithium oxide (Li₂O), sodium oxide (Na₂O), potassium oxide (K₂O), boron oxide (B₂O₃), vanadium oxide (V₂O₅), zinc oxide (ZnO), tellurium oxide (TeO₂) aluminum oxide (Al₂O₃), silicon dioxide (SiO₂), lead oxide (PbO), tin oxide (SnO), phosphorous oxide (P₂O₅), ruthenium oxide (Ru₂O), rubidium oxide (Rb₂O), rhodium oxide (Rh₂O), ferrite oxide (Fe₂O₃), copper oxide (CuO), titanium oxide (TiO₂), tungsten oxide (WO₃), bismuth oxide (Bi₂O₃), antimony oxide (Sb₂O₃), lead-borate glass, tin-phosphate glass, vanadate glass, and borsilicate.

17. A device according to any one of Claims 1 to 16, wherein the first surface of the frit seal and the non-conductive inorganic material layer are in contact along edges of the first substrate.

18. A method of fabricating an organic light emitting display, comprising:
providing a first substrate and an array of thin film transistors formed over the first substrate;
forming a non-conductive inorganic material layer over the array of thin film transistors;
forming an array of light emitting pixels over the non-conductive inorganic material layer;
arranging a second substrate over the first substrate such that the array of light emitting pixels are interposed between the first and second substrates; and
forming a frit seal between the first and second substrates such that the frit seal surrounds the array of light emitting pixels, wherein the frit seal contacts the non-conductive inorganic material layer.

19. A method according to Claim 18, further comprising forming a non-conductive organic material layer over the non-conductive inorganic material layer prior to forming the array of light emitting pixels, wherein prior to forming the frit seal, a portion of the non-conductive inorganic material layer is exposed, wherein the frit seal contacts the portion.

20. A method according to Claim 18 or 19, further comprising forming a plurality of via holes through the non-conductive inorganic material layer prior to forming the array of light emitting pixels, wherein electrically conductive connections are formed through the via holes so as to interconnect the array of organic light emitting pixels and the array of thin film transistors.

21. A method according to any one of Claims 18 to 20, wherein the non-conductive inorganic material layer is formed by spin coating.

22. An organic light emitting display device comprising:
a first substrate;
a second substrate;
an integrated structure formed on the first substrate, wherein the integrated structure comprises a planarization layer and an array of organic light emitting pixels, which comprises an anode, wherein the integrated structure further comprises an extension of the anode; and
a frit seal interposed between and interconnecting the first and second substrates while surrounding the array, the frit seal having a first surface facing the first substrate and a second surface facing the second substrate, wherein the second surface contacts the extension of the anode.

23. A device according to Claim 22, wherein the anode comprises an inorganic layer, wherein the anode is formed of at least one selected from the group consisting of Al, MoW, Mo, Cu, Ag, Al-alloy, Ag-alloy, ITO, IZO, and a semitransparent metal.

24. A device according to Claim 22 or 23, wherein the integrated structure further comprises an organic planarization layer interposed between the anode and the first substrate.

25. A device according to Claim 24, wherein the integrated structure further comprises an inorganic layer interposed between the anode and the organic planarization layer.

26. A device according to any one of Claims 22 to 25, wherein substantially the entirety of the first surface of the frit seal contacts the anode.

27. A device according to any one of Claims 22 to 26, wherein substantially the entirety of the first surface of the frit seal is fixed to the anode.
